# EUROPEAN PATENT APPLICATION

(11) **EP 3 416 240 A1**
(43) Date of publication of application: **19.12.2018**
(21) Application number: 18175208.0
(22) Date of filing: 30.05.2018
(51) Int. Cl.: H01Q 7/00, H01Q 1/38, H05K 1/11, H05K 1/14, H01Q 1/22, H01Q 1/40

(54) **ANTENNA APPARATUS AND ELECTRONIC APPARATUS**

(30) Priority: 13.06.2017 JP 2017116238
(71) Applicant: FUJITSU LIMITED, Kanagawa 211-8588 (JP)
(72) Inventor: BAN, Yasumitsu, Kawasaki-shi, Kanagawa 211-8588 (JP)
(74) Representative: Haseltine Lake LLP

(57) **Abstract**

An antenna apparatus includes: a conductive pattern formed in each of front and back surfaces of a dielectric, wherein the conductive pattern of the front surface is divided into two with a predetermined gap, and includes a feeding point in the gap, and wherein each of the conductive patterns divided into two is configured to be connected to the conductive pattern of the back surface through a connection portion with a predetermined length provided at a pair of diagonal portions.

## Description

### FIELD

The embodiments discussed herein are related to an antenna apparatus and an electronic apparatus including a loop antenna.

### BACKGROUND

As an antenna apparatus including a loop antenna, there is, for example, an RFID tag. The RFID tag is attached to parts at the time of a component manufacturing process and used for part management. In order to suppress an increase in the weight and size of the parts, the RFID tag is downsized, and in a case where the part is a metal, it has an overlapping structure in which a metal pattern is wound around a dielectric to overlap the antennas.

In the related art, as a loop antenna, for example, there is a structure in which two conductive plates face each other in a U shape. In addition, there is also a structure in which a conductor is folded on a substrate such as a resin so that patterns are continuous on front and back surfaces of the substrate. In addition, there is a structure in which cards of each layer on which coils are formed are stacked. In addition, there is a structure in which a coiled conductor is provided between a plurality of ceramic material layers and a plurality of coiled conductors are wound around the same central axis in the same direction.

### SUMMARY

### TECHNICAL PROBLEM

In the related art, it is not easy to manufacture an antenna with an overlapping structure and the number of manufacturing steps increases. For example, a process for forming a conductor of an antenna on the PET (polyethylene terephthalate) of a base material and pasting it on a core material such as a dielectric material and a process for folding the PET at a plurality of folding line portions to overlap a plurality of antenna faces respectively, are demanded.

In addition, when the bent portion of the antenna surface is not bent accurately, inclination occurs between the opposing antenna surfaces, so that the antenna surfaces after overlapping are misaligned and the antenna characteristics are deteriorated. For example, in a case of the PET, not only bulging occurs at the bent portion, but also it may bend without following the folding line. With this, a gap between the core member and the antenna surface (PET) and misalignment between a plurality of antenna surfaces occur such that a state in which they did not overlap accurately occurs. In order to provide the overlapping precision of the antenna faces, it is demanded to individually deal with the processes during the manufacturing process, which increases the number of steps.

According to one or more aspects described in the present description, provided are technologies for being able to easily obtain good antenna characteristics with a long loop length of a small size.

### SOLUTION TO PROBLEM

According to an embodiment of an aspect of the invention, antenna apparatus includes: a conductive pattern formed in each of front and back surfaces of a dielectric, wherein the conductive pattern of the front surface is divided into two with a predetermined gap, and includes a feeding point in the gap, and wherein each of the conductive patterns divided into two is configured to be connected to the conductive pattern of the back surface through a connection portion with a predetermined length provided at a pair of diagonal portions.

The object and advantages of the embodiment will be realized and attained by means of the elements and combinations particularly pointed out in the claims.

It is to be understood that both the foregoing general description and the following detailed description are exemplary and explanatory and are not restrictive of the embodiment, as claimed.

### ADVANTAGEOUS EFFECTS OF INVENTION

According to one or more aspects described in the present description, an effect that good antenna characteristic with a long loop length of a small size can be easily obtained.

### BRIEF DESCRIPTION OF DRAWINGS

The invention is described, by way of example only, with reference to the following drawings, in which:
FIG. 1 is a diagram illustrating an antenna apparatus according to Example 1.
FIG. 2 is a chart indicating communication characteristics of the antenna apparatus according to Example 1 (Part 1).
FIG. 3A is a diagram for explaining an inclination angle of a gap of the antenna apparatus according to Example 1.
FIG. 3B is a chart indicating the communication characteristics of the antenna apparatus according to Example 1 (Part 2).
FIG. 4 is a diagram for explaining miniaturization of the antenna apparatus of an embodiment.
FIG. 5 is an exploded perspective view illustrating an antenna apparatus according to Example 2 (Part 1).
FIG. 6 is an exploded perspective view of the antenna apparatus according to Example 2 (Part 2).
FIG. 7 is a chart indicating communication characteristics of the antenna apparatus according to Example 2.
FIG. 8 is a perspective view illustrating an antenna apparatus according to Example 3.
FIG. 9 is an exploded perspective view illustrating the antenna apparatus according to Example 3 (Part 1).
FIG. 10 is an exploded perspective view illustrating the antenna apparatus according to Example 3 (Part 2).
FIG. 11 is a chart indicating the communication characteristics of the antenna apparatus according to Example 3.
FIG. 12 is a diagram illustrating an antenna apparatus according to Example 4.
FIG. 13 is a diagram for explaining a position at which an opening of the antenna apparatus according to Example 4 is provided.
FIG. 14 is a chart indicating communication characteristics of the antenna apparatus according to Example 4.
FIG. 15A is a diagram illustrating a manufacturing process of an antenna apparatus by an existing overlapping structure (Part 1).
FIG. 15B is a diagram illustrating another manufacturing process of an antenna apparatus by an existing overlapping structure (Part 2).

### DESCRIPTION OF EMBODIMENTS

### < Example 1>

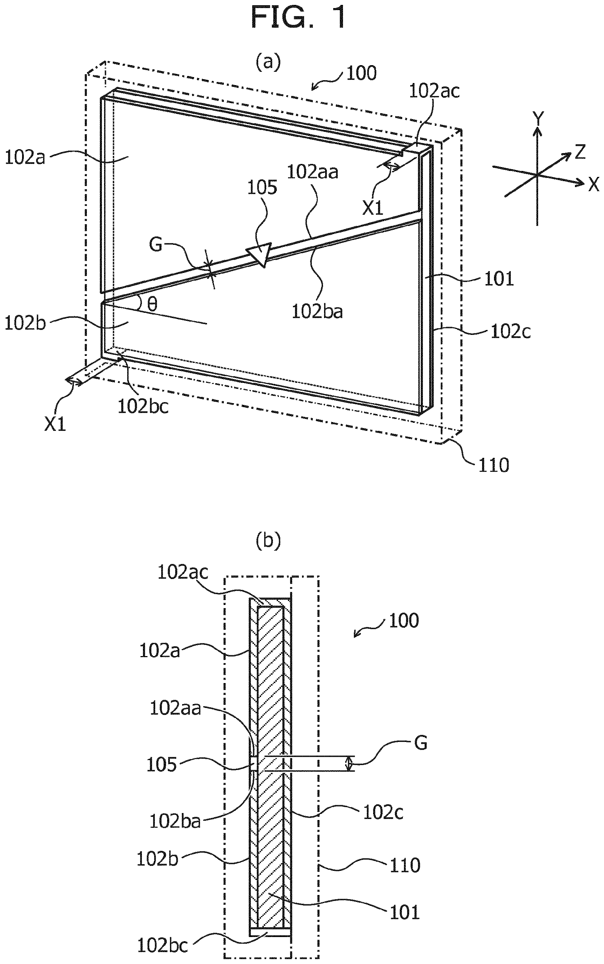

FIG. 1 is a diagram illustrating an antenna apparatus according to Example 1. FIG. 1(a) is a perspective view thereof, and FIG. 1(b) is a sectional view, which is cut at the center portion in a length direction (X-axis) of the antenna apparatus 100. An X-axis direction is a length, a Y-axis direction is a width, and a Z-axis direction is a thickness of an antenna apparatus 100. The antenna apparatus 100 includes a base material 101, a conductive pattern 102, an IC 105, and an exterior 110.

The base material 101 is made of a material such as PET. In an example of FIG. 1, the base material 101 is used as a core material having a predetermined thickness for holding the antenna apparatus 100, and is formed in a flat plate shape (cubic shape). In an example of FIG. 1, the length of the base material 101 is slightly larger than the width, the length of the X-axis is a long side, and the width of the Y axis is a short side. It is possible to implement a configuration in which a predetermined strength (rigidity) by attaching the base material 101 of a thin film such as PET to the core material of a predetermined thickness, is acquired.

On the base material 101, the conductive pattern 102 made of a conductive material of a predetermined pattern functioning as a loop antenna is formed. The conductive pattern 102 includes a first conductive pattern 102a and a second conductive pattern 102b which are formed by being divided into two parts on a front surface of the antenna apparatus 100 (base material 101), and a third conductive pattern 102c formed on a back surface of the antenna apparatus 100.

In a front surface side of the antenna apparatus 100 (base material 101), an end portion 102aa of the first conductive pattern 102a and an end portion 102ba of the second conductive pattern 102b are formed to be opposed to each other with a gap (groove) G having a predetermined gap therebetween. The gap G is formed continuously at approximately the center portion on the front surface side of the antenna apparatus 100 in a length direction. As described in FIG. 1, the gap G is provided to be a predetermined inclination angle θ (for example 35°) in the length direction (X-axis).

Then, the first conductive pattern 102a and the second conductive pattern 102b are conductively connected to the third conductive pattern 102c by connection portions 102ac and 102bc provided at two points of diagonal positions of the base material 101. Both connection portions 102ac and 102bc are provided at a position closest to the gap G on the long side of the base material 101.

The first conductive pattern 102a on the front surface side of the base material 101 is connected to the third conductive pattern 102c on the back surface side of the base material 101 through the connection portion 102ac at a position closest to the gap G (upper right of FIG. 1(a)). In addition, the second conductive pattern 102b on the front surface side of the base material 101 is connected to the third conductive pattern 102c on the back surface side of the base material 101 through the connection portion 102bc at a position (lower left of FIG. 1(a)) closest to the gap G.

As described above, the connection portions 102ac and 102bc are arranged at a position close to the gap G on the long side of the base material 101 such that it is possible to increase the loop length according to an inductance component L of the conductive pattern 102 at the time of functioning as the loop antenna. In addition, the connection portions 102ac and 102bc may have a predetermined short length X1 capable of conducting in the length direction (X-axis) of the base material 101. With this, it is possible to acquire the antenna apparatus 100 capable of maintaining and improving antenna characteristics even when the entire antenna is downsized.

In FIG. 1(a), the IC 105 is illustrated as a mark (Δ) indicating a disposition point and positive and negative polarity. More specifically, the IC 105 is provided in the center position (feeding point) of the gap G between the end portion 102aa of the first conductive pattern 102a and the end portion 102ba of the second conductive pattern 102b.

The IC 105 is formed in a chip shape, performs various processes of the antenna apparatus 100 such as a wireless communication process, and performs wireless communication with an external device (reader, writer, or the like) with the conductive pattern 102 as an antenna.

For example, the above-described antenna apparatus 100 can be used as an RFID tag attached to a manufactured part. For example, the RFID tag receives predetermined radio waves from the external device with respect to the component when the RFID tag passes through an external device corresponding to each process or inspection of the component. In this case, for example, the IC 105 transmits information of parts (identification information, manufacture information, or the like) stored in advance based on of received power to the external device by short-range radio or the like. With this, the RFID tag can wirelessly notify the external device of the information of the attached parts.

The above-described antenna apparatus 100 functions as, for example, the RFID tag, by mounting the IC 105 on the feeding point. However, the antenna apparatus 100 can be applied not only to the RFID tag but also to various types of the electronic apparatus which performs wireless communication with the external device, according to the function of the mounted IC 105. In addition, it is not demanded to mount the IC 105 at the feeding point and it is also possible to provide the antenna apparatus 100 connectable to a wireless communication unit by deriving the feeding point from the outside.

The exterior 110 is made of the dielectric or the like and covers the whole base material 101 corresponding to the outer diameter of the base material 101 on which the conductive pattern 102 is formed to protect it from external forces against the conductive pattern 102 and does not allow the conductive surface of the conductive pattern 102 to be positioned inside and exposed. With this, for example, the antenna apparatus 100 used as the RFID tag is protected in all directions by the exterior 110, and can also be used by being attached to parts such as metals.

For example, the antenna apparatus 100 forms the conductive pattern 102 on the front surface and the back surface of one base material 101 by etching or a 3D printer. In addition, the connection portions 102ac and 102bc of the conductive pattern 102 can be formed by using solder, a conductive gap having conductivity and having a concave shape sandwiching the base material 101, a via penetrating the base material 101, or the like. In this manner, the antenna apparatus 100 of Example 1 can be simply manufactured by a configuration different from an existing structure manufactured by folding and overlapping the conductive pattern.

Dimensions of each part of the antenna apparatus 100, for example, the size of the base material 101 including the conductive pattern 102 has a length of 31 mm, a width of 23 mm, and a thickness of 1.2 mm. The antenna apparatus 100 after sheathing with the exterior 110 is 35 mm in length, 25 mm in width, and 2 mm in thickness.

In addition, the IC 105 has an, for example, impedance is 1,700 Ω, 1.1 pF, and minimum operating power -11 dBm. The external device (reader and writer) performs mutual wireless communication with 4W equivalent isotropically radiated power (EIRP) and linearly polarized waves.

The third conductive pattern 102c may also be divided into two having the front surface. In this case, the gap provided in the third conductive pattern 102c may be provided at a predetermined position and have an inclination angle, and in a case of including the inclination angle, it may be provided at the same position as a position in which the inclination angle θ of the gap G on the front surface.

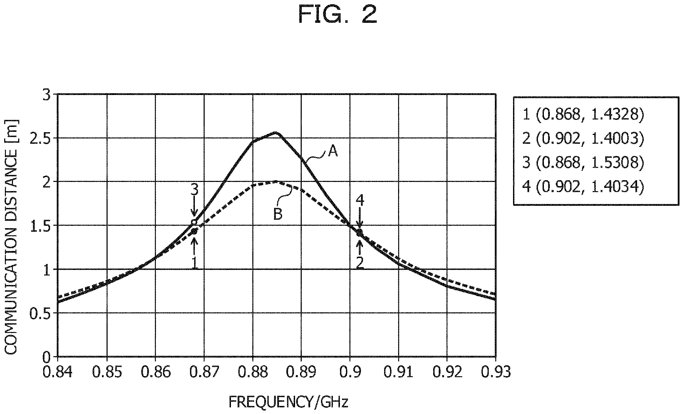

FIG. 2 is a chart indicating communication characteristics of the antenna apparatus according to Example 1. A horizontal axis is a frequency and a vertical axis is a communication distance. Characteristics A of the antenna apparatus 100 of Example 1 illustrated in FIG. 1 and characteristics B of the antenna apparatus formed by overlapping with an existing technology are illustrated.

As described in FIG. 2, between the upper limit of communication frequency of Europe (EU) (865 to 868 MHz) and the lower limit (902 to 928 MHz) of the communication frequency of US (US), both the existing technology and the antenna apparatus 100 according to Example 1 are approximately the same communication distance. All the center frequencies in FIG. 2 are 885 MHz, and characteristic deterioration does not occur.

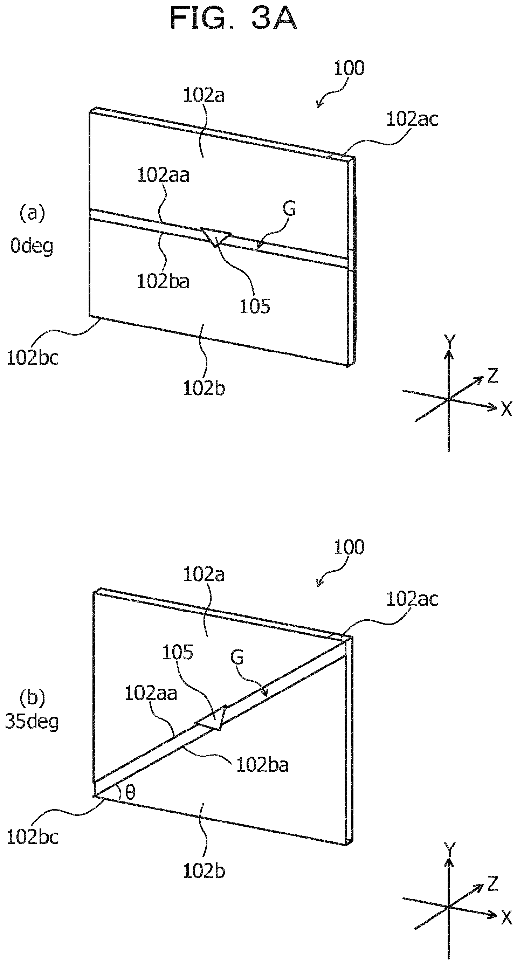

FIG. 3A is a diagram for explaining an inclination angle in a gap of the antenna apparatus according to Example 1. Antenna characteristics for the angle of the gap G of the antenna apparatus 100 in FIG. 2 will be described. FIG. 3A is a diagram for explaining the angle of the gap G, (a) is a diagram illustrating that the inclination angle θ of the gap G is 0° (deg), (b) is a diagram illustrating that the inclination angle of the gap G is 35°.

As described in (a) of FIG. 3A, in a case where the inclination angle θ is 0°, the end portion 102aa of the first conductive pattern 102a and the end portion 102ba of the second conductive pattern 102b are positioned in a horizontal length direction (X-axis). In addition, as described in (b) of FIG. 3A, in a case where the inclination angle θ is 35°, the end portion 102aa of the first conductive pattern 102a and the end portion 102ba of the second conductive pattern 102b are inclined at an inclination angle θ with respect to the horizontal length direction (X-axis). In a case where the antenna apparatus 100 (base material 101) is a dimension example (length is 31 mm and width is 23 mm) described above, it is 35° when the gap G connects the diagonal portions which are the longest on the base material 101.

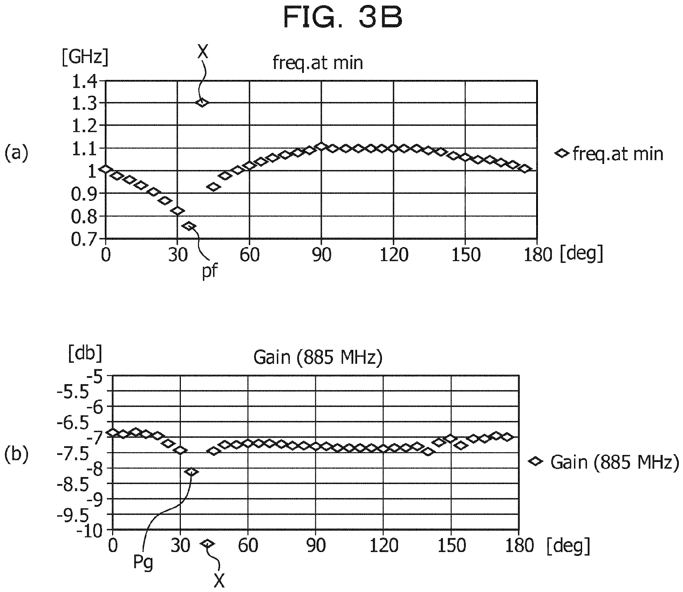

FIG. 3B is a chart indicating the communication characteristics of the antenna apparatus according to Example 1. The chart illustrates the antenna characteristics in a case of changing the inclination angle θ of the gap G in a range of 0° to 180°, and illustrates that the horizontal axis is the inclination angle θ. Then, in a case of impedance (1,700 Ω and 1.1 pF) of the IC 105, (a) indicates a frequency (GHz) at which |S11| (reflection component) of S parameter becomes the minimum and (b) indicates gain (dB) at the frequency of 885 MHz.

In (a) of FIG. 3B, when the inclination angle θ of the gap G gradually increases from 0°, the frequency gradually decreases and the inclination angle θ of a minimum point Pf is 35°. Then, as the inclination angle θ increases, the frequency increases. However, a singular point X is generated around 40° of the inclination angle θ close to the inclination angle θ 35° of minimum point Pf. Here, in (a) of FIG. 3B, it is desirable that the frequency be as low as possible.

In (b) of FIG. 3B, when the inclination angle θ of the gap G gradually increases from 0°, the gain gradually decreases, the inclination angle θ of the minimum point Pg where the characteristics continue is 35°. Then, as the inclination angle θ increases, the gain increases. However, the characteristics do not continue around 40° of the inclination angle θ close to the inclination angle θ 35° and the singular point X with significantly low gain is generated.

As described in FIG. 3B, it is desirable that the inclination angle θ of the gap G be selected as the optimum angle according to the combination of the gain in (b) and frequency at which |S11| in (a) is the minimum. In addition, it is demanded to make it an inclination angle θ excluding the singular point X. In a case where the antenna apparatus 100 (base material 101) has the dimension example (length is 31 mm and width 23 mm) as described above, according to FIG. 3B, it is preferable that the inclination angle θ of the gap G be 35° connecting the diagonal portions which are the longest on the base material 101.

As described above, the inclination angle θ of the gap G selects an angle in which the loop length of the conductive pattern 102 increases on the front surface side of the base material based on the length and width of the antenna apparatus 100 (base material 101).

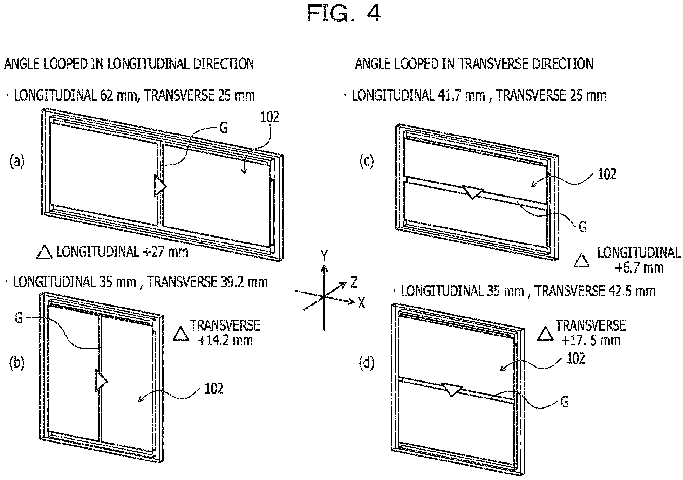

FIG. 4 is a diagram for explaining miniaturization of the antenna apparatus of the embodiment. (a) to (d) of FIG. 4 illustrate the dimensions of the antenna apparatus for obtaining characteristics similar to those of the antenna apparatus 100 (center frequency 885 MHz) indicated in Example 1. In the antenna apparatus in FIG. 4, each example of a case where the conductive pattern 102 is formed by simply folding back and forth on the base material 101 (corresponding to overlap) and the gap G is not inclined (inclination angle θ = 0°), is illustrated.

As illustrated in FIG. 4(a), in a case where the conductive pattern 102 is looped in the longitudinal direction of the antenna apparatus 100 (gap G is in Y-axis direction), the length in the longitudinal direction (X-axis) is 62 mm and the length of the transverse direction (Y-axis) is 25 mm. In addition, as illustrated in FIG. 4(b), it is assumed that the conductive pattern 102 is looped in the longitudinal direction of the antenna apparatus 100 (gap G is in Y-axis direction) such that the length in the longitudinal direction and the length in the transverse direction are approached each other. In this case, as compared with FIG. 4(a), the length in the longitudinal direction (X-axis) is 35 mm and length in the transverse direction (Y-axis) is 39.2 mm (+ 14.2 mm).

In addition, as illustrated in FIG. 4(c), in a case where the conductive pattern 102 is looped in the transverse direction of the antenna apparatus 100 (gap G is in X-axis direction), as compared with FIG. 4(b), the length in the longitudinal direction (X-axis) is 41.7 mm (+ 6.7 mm) and the length in the transverse direction (Y-axis) is 25 mm. In addition, as illustrated in FIG. 4(d), it is assumed that the conductive pattern 102 is looped in the transverse direction of the antenna apparatus 100 (gap G is in X-axis direction) such that the length in the longitudinal direction and the length in the transverse direction are approximated. In this case, as compared with FIG. 4(c), the length in the longitudinal direction (X-axis) is 35mm and the length in the transverse direction (Y-axis) is 42.5 mm (+ 17.5 mm).

As described in (a) to (d) of FIG. 4, in a case where the gap G of the conductive pattern 102 is not inclined but simply overlapped, it is indicated that both of them are larger than the antenna apparatus 100 having the inclination angle θ in the gap G as described above.

According to Example 1 described above, the conductive pattern is provided on the front and back surfaces of the core material, and a gap dividing the conductive pattern connected in the vicinity of the diagonal portions of the core material is provided. Then, the conductive pattern divided on the front surface of the core material is connected to the conductive pattern of the back surface in the vicinity of the diagonal portion. With this, it is possible to reduce the dimension, to increase the loop length of the conductive patterns on the front and back surfaces, and to improve the antenna characteristics.

### < Example 2>

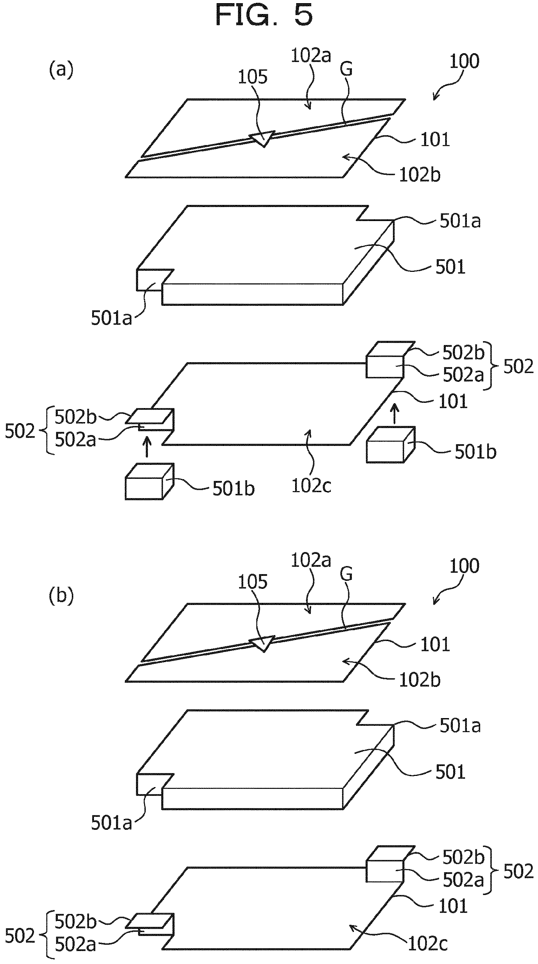

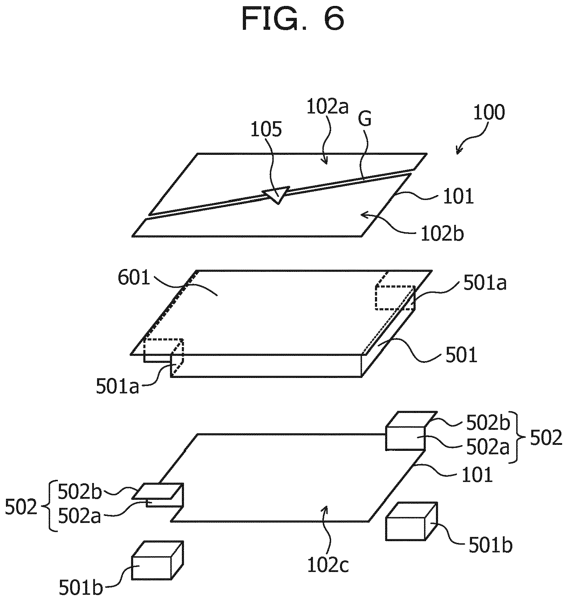

FIG. 5 and FIG. 6 are exploded perspective views illustrating an antenna apparatus according to Example 2. The above-described Example 1 is a basic structure and in each of the following embodiments, other structure examples of the antenna apparatus 100 will be described.

Example 2 is mainly an example of a multilayer structure in which the core material and the base material on which the conductive pattern is formed are bonded with an adhesive or the like. In FIG. 5 and FIG. 6, configuration parts similar to those of Example 1 are denoted by the same reference numerals. In the following description, the description of the exterior 110 covering the entire antenna apparatus 100 and the notation of a diagram may be omitted.

The antenna apparatus 100 illustrated in FIG. 5(a) has a three-layered structure in which the base material 101 on which the conductive pattern 102 is formed is adhered to on each of the front and back surfaces of the core material 501 with a predetermined strength (rigidity). The material of the core material 501 is, for example, a dielectric such as rubber having a predetermined thickness, and the material of the base material 101 is, for example, a PET film. The base material 101 on which the core material 501 and the conductive pattern 102 are formed is formed with the same dimension as that of Example 1 (external dimension).

On the front surface side of the antenna apparatus 100, the conductive pattern 102 is disposed toward the core material 501 (on back surface of base material 101 in FIG. 5). Similar to Example 1 (see FIG. 1 or the like), the conductive pattern 102 on the front surface side is provided such that the first conductive pattern 102a and the second conductive pattern 102b which are divided into two have the gap G of the inclination angle θ.

In addition, on the back surface side of the antenna apparatus 100, the conductive pattern 102 is disposed toward the core material 501 (on front surface of base material 101 in FIG. 5). For example, similar to Example 1 (see FIG. 1 or the like), the conductive pattern 102 of the back surface side is formed on the entire surface of the base material 101.

Then, similar to Example 1, the conductive pattern 102 (102a and 102b) of the front surface side is conductively connected to the conductive pattern 102 (102c) of the back surface side in each of the diagonal positions. Here, each of the connection units 502 conductively connected to the conductive pattern 102c is provided on the diagonal position of the conductive pattern 102c of the back surface side.

The connection unit 502 is formed by being bent with respect to a surface of the conductive pattern 102c together with the base material 101. The connection unit 502 includes a contact surface 502b in contact with each of a side surface 502a corresponding to the thickness of the core material 501 and the conductive patterns 102a and 102b.

The connection unit 502 is formed with a notch in a direction (Y-axis) intersecting the longitudinal direction (X-axis) of the antenna apparatus 100 (base material 101), and the side surface 502a and the contact surface 502b are formed by being bent. By providing the notch in a direction intersecting the longitudinal direction (X-axis) of the connection unit 502, the antenna length can be implemented longer as compared with a case where the notch is provided parallel to the longitudinal direction (X-axis).

On the core material 501, each of the notched portions 501a on the diagonal portion in which the connection unit 502 of the conductive pattern 102 is positioned.

Then, the base material 101 on which the conductive patterns 102a and 102b of the front surface side are formed is attached to the front surface of the core material 501. In addition, on the back surface of the core material 501, the base material 101 on which the conductive pattern 102c of the back surface side is formed is attached with an adhesive or the like.

At this time, the contact surfaces 502b of the connection unit 502 formed on the diagonal portion of the conductive pattern 102c on the back surface side come into contact with the diagonal portions of the conductive patterns 102a and 102b on the front surface side, and are attached with a conductive adhesive or the like.

In addition, 501b illustrated in FIG. 5(a) is a replenishment material attached to the notched portion 501a of the core material 501. For example, the replenishment material 501b is a member removed when the notched portion 501a is formed on the core material 501, and has a size (length, width, and thickness) corresponding to the outer diameter of the notched portion 501a. More precisely, the replenishment material 501b is formed to have a portion which is in contact with the connection portions 502 (502a and 502b) to be thin by the thickness of the connection portions 502 (base material 101 and conductive pattern 102).

As described above, after the conductive pattern 102 is attached to the front and back surfaces of the core material 501, the replenishment material 501b is fixed to the notched portion 501a with an adhesive or the like. With this, it is possible to stably come the connection unit 502 positioned at the notched portion 501a into contact with the conductive patterns 102a and 102b.

FIG. 5(b) has the same configuration as that of FIG. 5(a) except that there is no the replenishment material 501b. Even in a case where the replenishment material 501b is not provided, it is possible to adopt a configuration in which the notched portion 501a is filled at the time of forming the exterior 110 or with other replenishment material or the like.

In an example of the antenna apparatus 100 illustrated in FIG. 6, an adhesive layer 601 is disposed on the front surface of the core material 501 in addition to the configuration of each part illustrated in FIG. 5(a). The adhesive layer 601 has an adhesive surface on both surfaces of a double-sided tape or the like, and has a thickness of, for example, 0.1 mm. The adhesive layer 601 is configured not to have conductivity. The adhesive layer 601 has a size (length and width) corresponding to the outer diameter of the core material 501, and is also provided on the upper portion of the notched portion 501a.

According to a configuration of FIG. 6, by the adhesive layer 601, it is possible to easily bond between the core material 501 and the base material 101 on which the conductive pattern 102 is formed. In an example of FIG. 6, the adhesive layer 601 is provided only on the front surface of the core material 501. However, the adhesive layer 601 can be similarly provided on the back surface of the core material 501.

In addition, the connection unit 502 of the third conductive pattern 102c of the back surface is connected to the first conductive pattern 102a and the second conductive pattern 102b of the front surface through the adhesive layer 601 having no conductivity.

The adhesive layer 601 is the above-described thickness (0.1 mm), and even when the connecting portion 502 does not directly contact the first conductive pattern 102a and the second conductive pattern 102b, the adhesive layer 601 can couple the conductive patterns 102c each other at a high frequency, and predetermined antenna characteristics can be obtained. In addition, the adhesive layer 601 may be divided into two along the position of the gap G between the first conductive pattern 102a and the second conductive pattern 102b.

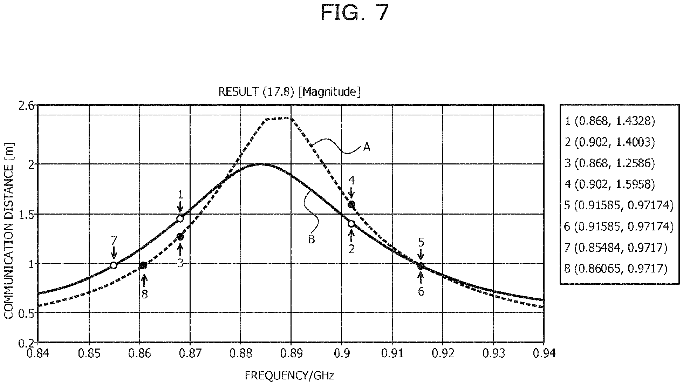

FIG. 7 is a chart indicating the communication characteristics of the antenna apparatus according to Example 2. The horizontal axis is the frequency and the vertical axis is the communication distance. The characteristics A of the antenna apparatus 100 in Example 2 and the characteristics B of the antenna apparatus formed by being overlapped by the existing technology are indicated.

As described in FIG. 7, between the upper limit (865 MHz to 868 MHz) of the communication frequency of the EU and the lower limit (902 MHz to 928 MHz) of the communication frequency of US, both the existing technology and the antenna apparatus 100 according to Example 2 have approximately the same communication characteristics.

According to the above-described Example 2, even in a case of the three-layered structure formed by the base materials on the front and back surfaces on which the core material and the conductive pattern are formed, Example 2 has the same effect as that of Example 1. That is, in the conductive pattern on the front surface side, the conductive pattern connected in the vicinity of the diagonal portions is divided by the gap, and the divided conductive patterns are connected to the conductive pattern on the back side in the vicinity of the diagonal portion. With this, it is possible to reduce the dimension, to increase the loop length of the conductive patterns on the front and back surfaces longer, and to improve the antenna characteristics.

Then, according to Example 2, it is possible to form in advance the conductive pattern provided on the front and back surfaces of the core material as a different layer in a different process, and it is possible to simply manufacture the base material of the conductive pattern by only attaching on the front and back surfaces of the core material.

### < Example 3>

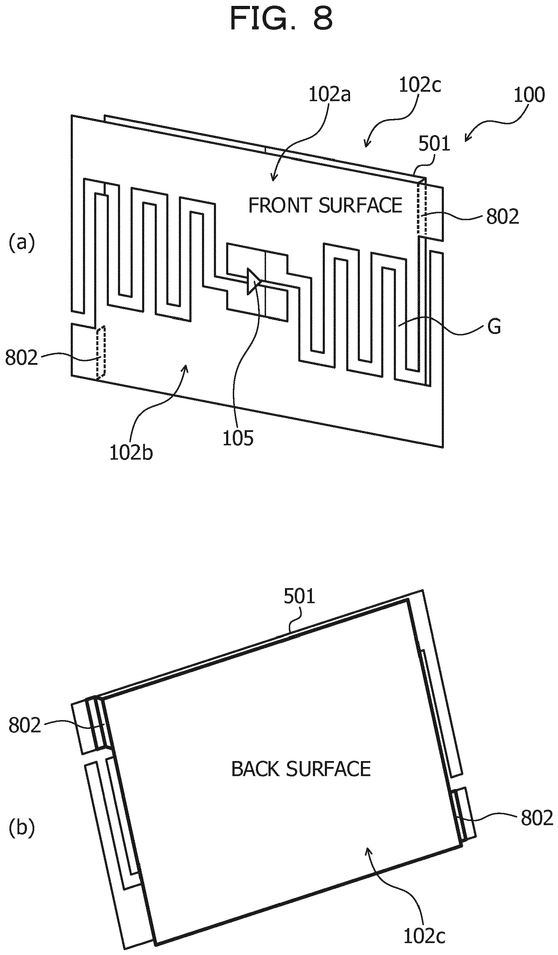

FIG. 8 is a perspective view illustrating an antenna apparatus according to Example 3. FIG. 8(a) is a perspective view of the antenna apparatus 100 as viewed from the front surface, and FIG. 8(b) is a perspective view as viewed from the back surface.

As described in FIG. 8(a), the conductive pattern 102 on the front surface of the antenna apparatus 100 is divided into two at the center of the long side such that the first conductive pattern 102a is provided on the upper half portion thereof and the second conductive pattern 102b is provided on the lower half portion. The first conductive pattern 102a and the second conductive pattern 102b are provided toward a core material 501 side on the base material 101 (on back surface of FIG. 8(a)) similar to Example 2.

The first conductive pattern 102a and the second conductive pattern 102b are formed in a comb teeth shape so as to enter into mutual regions, and correspondingly the gap G between the first conductive pattern 102a and the second conductive pattern 102b is formed by meandering in the vertical direction. With such an interdigital structure, the antenna apparatus 100 can increase the inductance in a limited size, and the loop length of the loop antenna can be made as long as possible. A capacitance of a predetermined capacity is provided in the power feeding unit or the like where the IC 105 is provided.

As described in FIG. 8(b), the conductive pattern 102 on the back surface of the antenna apparatus 100 provides the third conductive pattern 102c on the entire surfaces of the base material 101. The third conductive pattern 102c is also provided toward the core material 501 side (on back surface of FIG. 8(b)) on the base material 101, similar to Example 2.

On the third conductive pattern 102c, connection units 802 are provided on the diagonal portion, similar to Example 2. One of the connection units 802 connects the third conductive pattern 102c to the first conductive pattern 102a, and the other of the connection units 802 connects the third conductive pattern 102c to the second conductive pattern 102b.

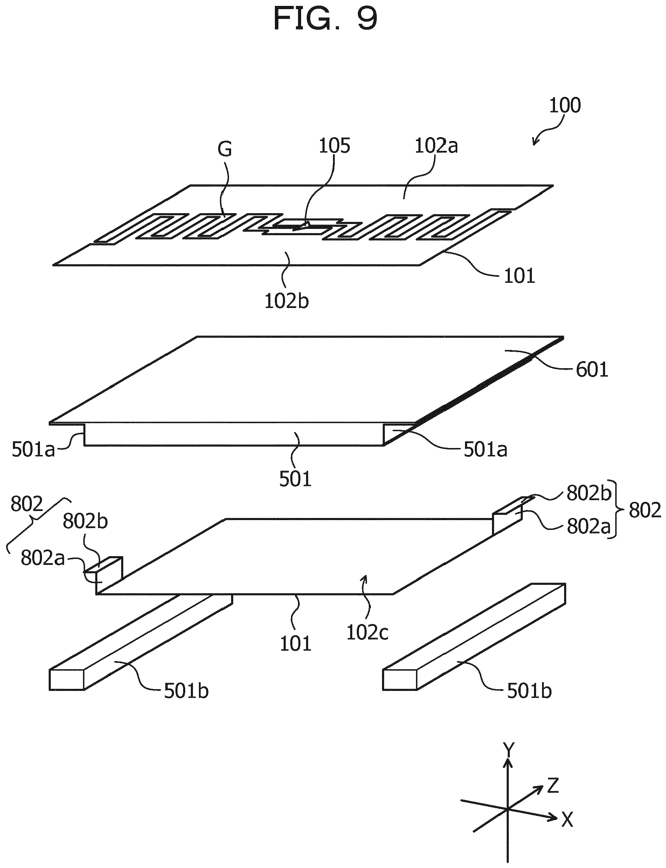

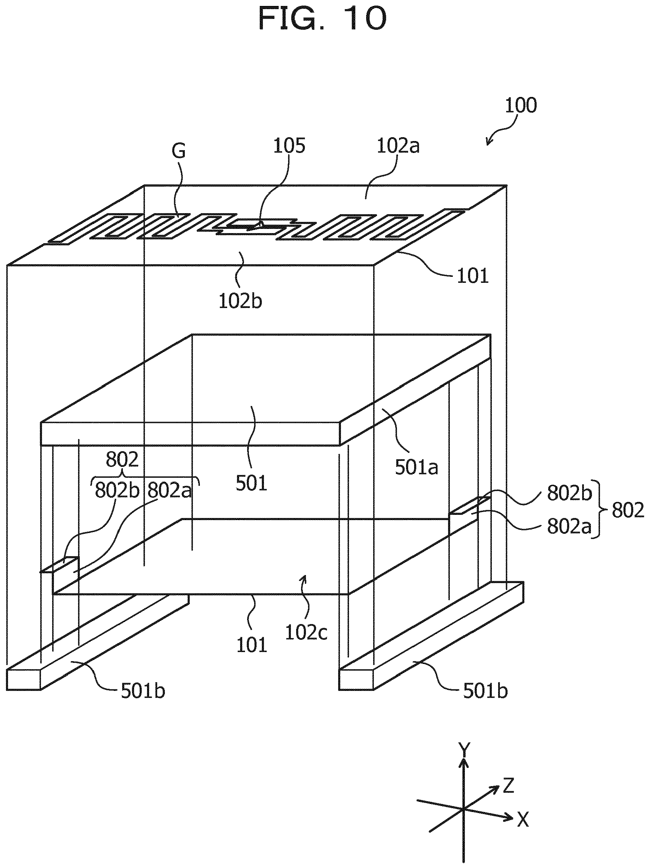

FIG. 9 and FIG. 10 are exploded perspective views illustrating an antenna apparatus according to Example 3. In an example of FIG. 9, the base material 101 on which the first conductive pattern 102a and the second conductive pattern 102b are formed on the back surface (core material 501 side) is attached to the front surface of the core material 501 side. In addition, the base material 101 on which the third conductive pattern 102c is formed on the front surface (core material 501 side) is attached to the back surface of the core material 501 side.

On the third conductive pattern 102c, the connection units 802 are formed on the diagonal portion of the base material 101. Each of the connection unit 802 includes side surfaces 802a corresponding to the thickness of the core material 501 from one diagonal portion of the third conductive pattern 102c and contact surfaces 802b facing each of the conductive patterns 102a and 102b, respectively. The contact surface 802b of one of the connection units 802 is connected to the first conductive pattern 102a, and the contact surface 802b of the other of the connection units 802 is connected to the second conductive pattern 102b.

In an example of FIG. 9, on the core material 501, similar to Example 2 (FIG. 6), the adhesive layer 601 is provided, the base material 101 on which the first conductive pattern 102a and the second conductive pattern 102b are formed is bonded and held on the front surface of the core material 501. The contact surface 802b of the connection unit 802 is connected to the first conductive pattern 102a and the second conductive pattern 102b through the adhesive layer 601.

In addition, 501b is the replenishment material which is attached to the notched portion 501a of the core material 501. For example, the replenishment material 501b is a member removed when the notched portion 501a is formed in the core material 501, and has a size (length, width, and thickness) corresponding to the outer diameter of the notched portion 501a. Since the replenishment material 501b is a member extending in the full-width direction (Y-axis) of the core material 501, it is possible to save time and labor of notching the length (X-axis) and the width (Y-axis) as in Example 2, and since it has a predetermined size, it is easy to handle and it can easily be assembled.

FIG. 10 is a configuration in which the adhesive layer 601 described in FIG. 9 is omitted. In this case, the contact surface 802b of the connection unit 802 is directly connected to the first conductive pattern 102a and the second conductive pattern 102b.

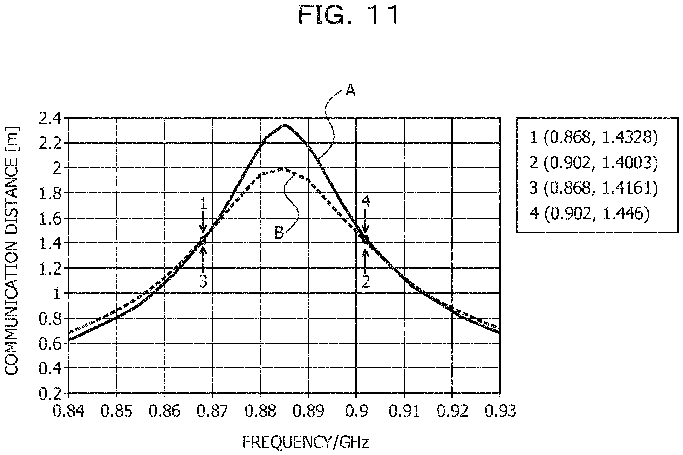

FIG. 11 is a chart indicating the communication characteristics of the antenna apparatus according to Example 3. The horizontal axis is the frequency and the vertical axis is the communication distance. As described in FIG. 11, between the upper limit (865 MHz to 868 MHz) of the communication frequency of the EU and the lower limit (902 MHz to 928 MHz) of the communication frequency of US, both the existing technology and the antenna apparatus 100 according to Example 3 have approximately the same communication characteristics. For example, the existing technology has the interdigital structure of the above-described Japanese Laid-open Patent Publication No. 2016-213812 or the like.

According to Example 3 described above, even in a case of the three-layered structure made of the base materials on the front and back surfaces on which the core material and the conductive pattern of the interdigital structure are formed, it has the same effect as that of Example 1. That is, the conductive pattern on the front surface side connects the conductive pattern divided by the gap to the conductive pattern of the back surface in the vicinity of the diagonal portion. With this, it is possible to reduce the dimension, to increase the loop length of the conductive patterns on the front and back surfaces longer, and to improve the antenna characteristics.

In addition, according to Example 3, similar to Example 2, according to Example 2, it is possible to form in advance the conductive pattern provided on the front and back surfaces of the core material as a different layer in a different process, and it is possible to simply manufacture the base material of the conductive pattern by only attaching on the front and back surfaces of the core material.

Then, as illustrated in Example 3, it is possible to apply the first conductive pattern and the second conductive pattern of the front surface side to the existing interdigital structure. By connecting the first conductive pattern and the second conductive pattern of the front surface side to the third conductive pattern on the back surface side at the diagonal position, it is possible to easily manufacture the antenna apparatus having a small size and excellent antenna characteristics.

### < Example 4>

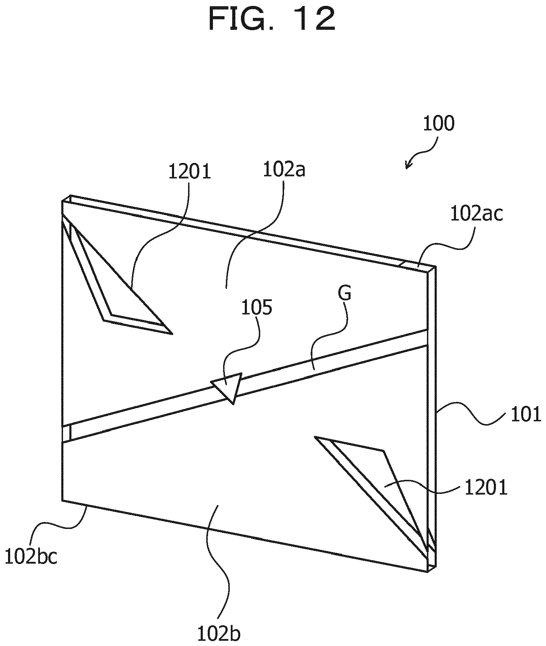

FIG. 12 is a diagram illustrating an antenna apparatus according to Example 4. Example 4 is a modification example of the antenna apparatus 100 described in Example 1. The configuration and dimension of each part are the same as those of Example 1, and the same reference numerals are given to the same constituent parts.

In Example 4, an opening 1201 passing through the front and back surfaces is formed. The opening 1201 passes through the conductive pattern 102 and the base material 101 of the front surface side, the core material 501, and the conductive pattern 102 of the back surface side.

As described in FIG. 12, the two openings 1201 are provided in the vicinity of remaining diagonal positions other than a pair of diagonal positions on which the connection portions 102ac and 102bc are provided.

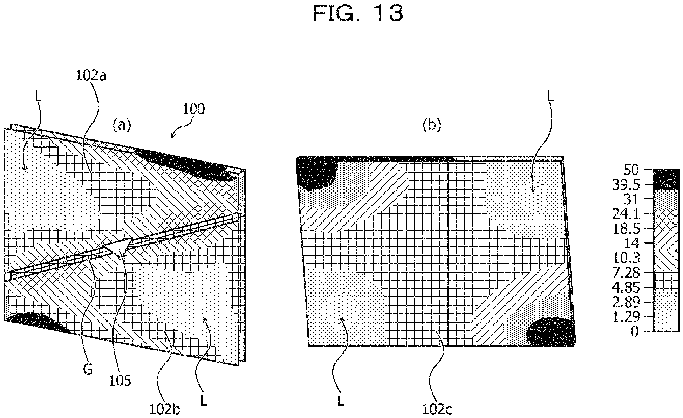

FIG. 13 is a diagram for explaining a position in which the opening of the antenna apparatus according to Example 4 is provided. In FIG. 13, the antenna apparatus 100 of Example 1, that is, electromagnetic field simulation of current distribution (870 MHz) in a state where the openings 1201 are not provided is illustrated. FIG. 13(a) illustrates the current distribution on the front surface side of the antenna apparatus 100, and FIG. 13(b) illustrates the current distribution on the back surface side of the antenna apparatus 100.

As described in these diagrams, since region L in which the current distribution is low does not affect the antenna characteristics, it is possible to provide the opening 1201. Positions illustrated in FIG. 13 correspond to two positions in the vicinity of the remaining diagonal positions other than the pair of the diagonal positions on which the connection portions 102ac and 102bc illustrated in FIG. 12 are provided.

In examples illustrated in FIG. 13, the opening 1201 is acquired by forming continued triangular notches on an end face of the base material 101 (and core material 501). In addition, the opening 1201 may be formed by punching or the like at a position separated from the end face of the base material 101 (and core material 501).

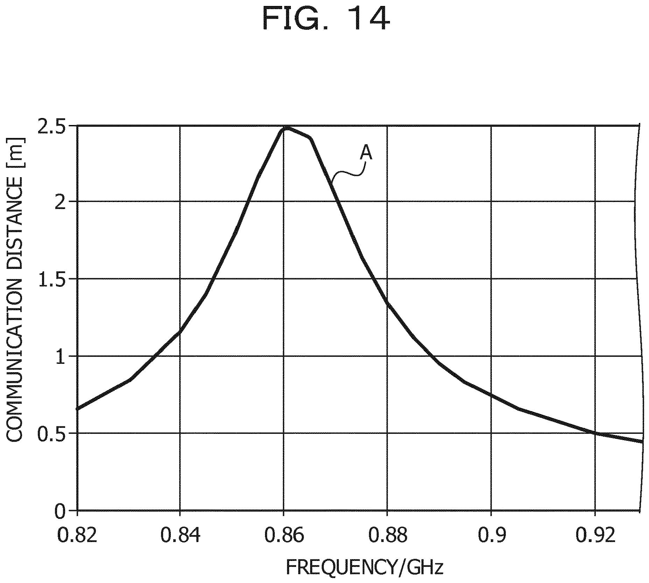

FIG. 14 is a chart indicating the communication characteristics of the antenna apparatus according to Example 4. The horizontal axis is the frequency and the vertical axis is the communication distance. The characteristics A of the antenna apparatus 100 in Example 4 has the center frequency (0.865 MHz) shifted downward with respect to the characteristics of Example 1, but approximately the same communication distance can be obtained.

According to Example 4, in addition to the same operation and effect as those of Example 1, by forming the opening, the antenna apparatus can be made flexible and the antenna apparatus can be easily bent. Meanwhile, even when bending force is applied to the antenna apparatus, it is possible to suppress damage.

### <Comparison with Existing Technology>

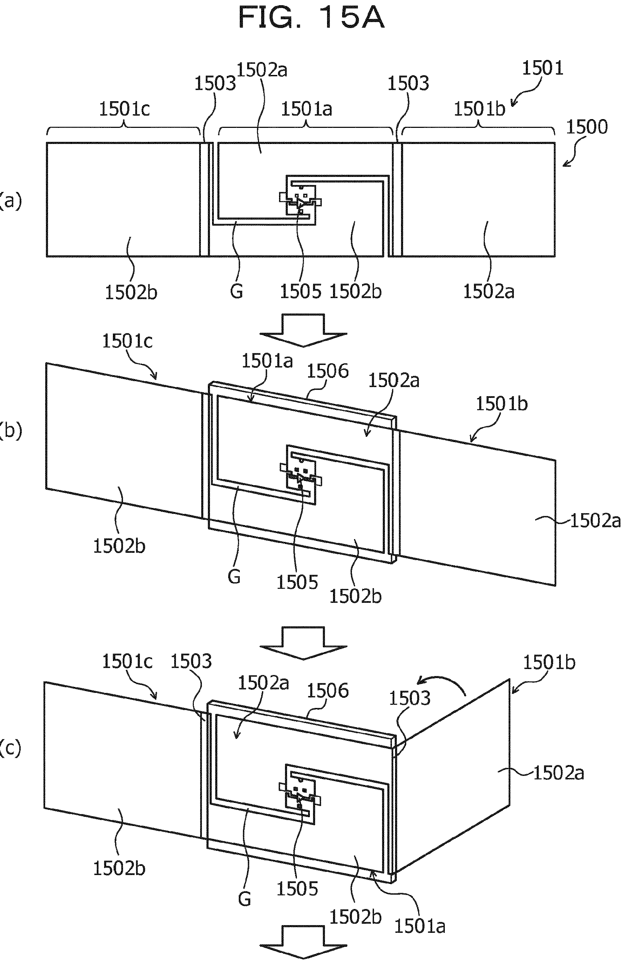

Next, the antenna apparatus according to the existing technology and the antenna apparatus according to the above-described embodiment will be described in comparison. FIG. 15A to FIG. 15B are diagrams illustrating a manufacturing process of the antenna apparatus with an existing overlapping structure.

As described in (a) of FIG. 15A, in the antenna apparatus 1500, the first conductive pattern 1502a and the second conductive pattern 1502b of the interdigital structure are formed on the front surface of the center portion 1501a of a base material 1501 which is divided into three such as PET with the gap G of a predetermined shape.

In the base material 1501, the side portions 1501b and 1501c provided on the right and left sides through a bending portion 1503 have the same outer diameter (width and length) with respect to the center portion 1501a, and each thereof is bendable to the central portion 1501a. The first conductive pattern 1502a is formed continuously on the front surface of one side portion 1501b, and the second conductive pattern 1502b is formed continuously on the front surface of the other side portion 1501c.

An IC 1505 is provided on the center position of the center portion 1501a of the base material 1501, and the IC 1505 is connected to the first conductive pattern 1502a and the second conductive pattern 1502b through the power feeding unit.

Then, as described in (b) of FIG. 15A, the core material 1506 made of the dielectric such as rubber is attached to the center portion 1501a. For example, the core material 1506 is attached on the front surface of the center portion 1501a.

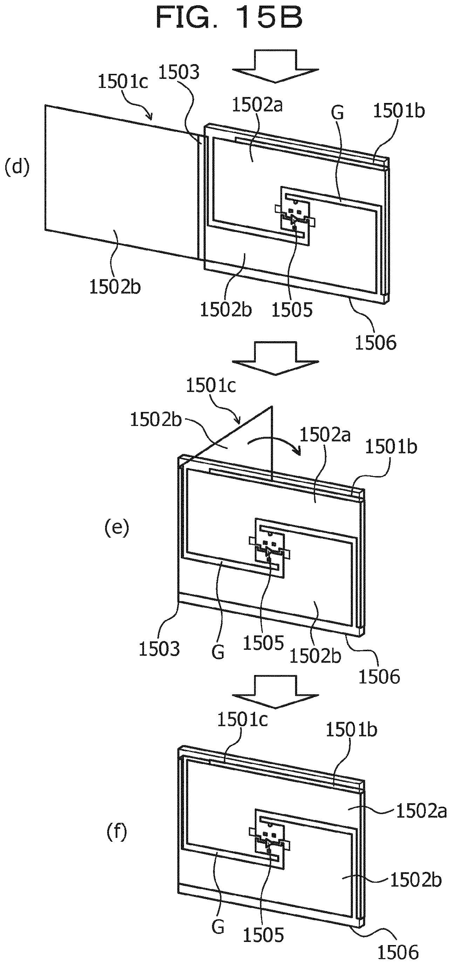

Then, as described in (c) of FIG. 15A, one side portion 1501b is bent to the back surface side around the bending portion 1503. With this, as described in (d) of FIG. 15B, one side portion 1501b is in a state of being overlapped with the back surface side of the center portion 1501a.

Then, as described in (e) of FIG. 15B, the other side portion 1501c is bent to the back surface side around the bending portion 1503. With this, as described in (f) of FIG. 15B, the other side portion 1501c is in a state of being overlapped with the back surface side of the center portion 1501a.

At this time, the first conductive pattern 1502a formed on the front surface of one side portion 1501b and the second conductive pattern 1502b formed on the front surface of the other side portion 1501c are positioned by interposing the side portion 1501b and the side portion 1501c that are the base material 1501 therebetween. The first conductive pattern 1502a and the second conductive pattern 1502b are in a non-contact (non-conduction) state.

In the case of such an existing overlapped structure, a time for manufacturing the antenna apparatus 1500 is demanded. Here, the side portions 1501b and 1501c of the base material 1501 illustrated in (c) of FIG. 15A and (e) of FIG. 15B are bent at the same time. Even in this case, it is demanded that the core material 1506 of (b) of FIG. 15A is attached to the base material 1501 and one side portion 1501b of (c) of FIG. 15A is attached to the center portion 1501a of the base material. Furthermore, it is demanded that the other side portion 1501c of (e) of FIG. 15B is attached to the center portion 1501a of the base material and the entire manufacturing time demanded for manufacturing increases.

Furthermore, when one and the other of the side portions 1501b and 1501c are bent, for example, in a case where the base material 1501 is the PET, a gap between the center portion 1501a in which a bulge is formed on the bending portion 1503 and the side portions 1501b and 1501c is generated. In addition, the side portions 1501b and 1501c may be bent along the bending portion 1503 without following along a bending line. With this, when an inclination occurs in the overlapped side portions 1501b and 1501c with respect to the center portion 1501a, the antenna characteristics are deteriorated.

In order to reduce these problems, to give the accuracy of overlapping of the antenna faces to each other, the number of manufacturing steps, for example, the worker individually checks and manually works for each product during the manufacturing process or the like, increases and the antenna is not easily manufactured.

On the other hand, in the embodiment, without folding the base material itself serving as the antenna surface, since the antenna is formed in the multilayer structure, there is no inconvenience such as inclination of the antenna surfaces caused by the existing overlap, the occurrence of bulging at the bent portion, and the like. With this, it is possible to easily and more accurately manufacture the antenna as compared with the manufacturing by using the existing overlap structure and it is possible to acquire a predetermined antenna precision.

According to the embodiment described above, it is implemented as a configuration in which the conductive pattern is provided on the front and back surfaces of the core material, the gap dividing the conductive pattern is provided so as to connect adjacent diagonal portions of the core material, and the conductive pattern divided on the surface of the core material is connected to the conductive pattern on the back side in the vicinity of the diagonal portion. With this, it is possible to increase the loop length of the conductive patterns on the front and back surfaces while reducing the size of the entire antenna apparatus and to improve the antenna characteristics.

In addition, the multilayer structure can be formed in which the antenna apparatus is implemented with the core material and the conductive pattern to be attached to the core material. For example, the three-layered structure in which the base material on which the conductive pattern is formed on the front and back surfaces of the core material is attached. Even in the multilayer structure, the conductive pattern on the front surface side divides the conductive pattern connected in the vicinity of the diagonal portions by the gap, the divided conductive pattern is connected to the conductive pattern of the back surface in the vicinity of the diagonal. With this, it is possible to reduce the dimension of the entire antenna apparatus, to increase the loop length of the conductive patterns on the front and back surfaces, and to improve the antenna characteristics. In addition, the conductive patterns provided on the front and back surfaces of the core material are different layers, can be previously formed in separate processes, and can be easily manufactured by only attaching the base material of the conductive pattern on the front and back surfaces of the core material.

Furthermore, the multilayer structure can be implemented by the core material and the base materials on the front and back surfaces on which the conductive pattern of the interdigital structure is formed. In this case, the conductive pattern on the front surface side connects the conductive pattern divided by the gap to the conductive pattern of the back surface in the vicinity of the diagonal portions. With this, by the conductive pattern of the interdigital structure, it is possible to reduce the dimension of the entire antenna apparatus, to increase the loop length of the conductive patterns on the front and back surfaces longer, and to improve the antenna characteristics.

Furthermore, the opening is formed on a region with low current distribution by passing through the front and back surfaces of the antenna apparatus such that the antenna apparatus can be manufactured flexible and the antenna apparatus can be easily bent. In addition, even when bending force is applied to the antenna apparatus, it is possible to suppress damage.

All examples and conditional language recited herein of the RFID tag and the high frequency circuit are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the scope of the invention.

### Reference Signs List

100antenna apparatus
101base material
102conductive pattern
102afirst conductive pattern
102bsecond conductive pattern
102cthird conductive pattern
102ac, 102bc, 502, 802connection portion
105IC
110exterior
501core material
501anotch
501breplenishment material
502aside surface
502bcontact surface
601adhesive layer
802aside surface
802bcontact surface
Ggap

### Citation List

[Patent Literature 1] Japanese Laid-open Patent Publication No. 6-244618
[Patent Literature 2] Japanese Laid-open Patent Publication No. 2016-213812
[Patent Literature 3] Japanese National Publication of International Patent Application No. 2004-530212
[Patent Literature 4] Japanese Laid-open Patent Publication No. 2014-052756

## Claims

1. An antenna apparatus comprising:
a conductive pattern formed in each of front and back surfaces of a dielectric,
wherein the conductive pattern of the front surface is divided into two with a predetermined gap, and includes a feeding point in the gap, and
wherein each of the conductive patterns divided into two is configured to be connected to the conductive pattern of the back surface through a connection portion with a predetermined length provided at a pair of diagonal portions.

2. The antenna apparatus according to claim 1,
wherein the gap is provided to have an inclination angle with respect to a side of the dielectric, and
wherein the inclination angle is configured to increase a loop length of the conductive pattern that is divided into two based on a length or a width of the dielectric.

3. The antenna apparatus according to claim 2,
wherein the inclination angle of the gap is set based on a frequency and gain at which S parameter becomes minimum.

4. The antenna apparatus according to any preceding claim,
wherein the gap is provided to have a predetermined angle connecting the pair of diagonal portions in which the connection portion is provided to each other.

5. The antenna apparatus according to any preceding claim,
wherein the connection portion is any one of a conductive gap, a via, and soldering which conductively connects the conductive patterns of the front and back surfaces in the pair of diagonal portions.

6. The antenna apparatus according to any preceding claim,
wherein the conductive pattern is formed by etching the front surface of the dielectric or by a 3D printer.

7. The antenna apparatus according to any preceding claim,
wherein the conductive pattern is formed on a dielectric film, and has a multilayer structure in which the film is attached to the front and back surfaces of a core material with a predetermined thickness.

8. The antenna apparatus according to claim 7,
wherein each of the conductive patterns of the front and back surfaces is attached to the dielectric in contact with a dielectric side, and a contact surface is formed by bending the conductive pattern of the back surface,
a notch is provided on the connection portion of the core material, and
the contact surface of the conductive pattern of the back surface is conductively connected to the conductive pattern of the front surface through the notch.

9. The antenna apparatus according to claim 8,
wherein a replenishment material of the dielectric interposed and held on the contact surface of the conductive pattern is disposed in the notch.

10. The antenna apparatus according to claim 8 or claim 9,
wherein the contact surface is formed on the conductive pattern of the back surface by the notch corresponding to a direction in which the loop length increases.

11. The antenna apparatus according to claim 8, 9 or 10,
wherein a thin adhesive layer is provided between the core material and the conductive patterns of the front and back surfaces, and
the contact surface is coupled with the conductive pattern of the front surface in a high-frequency manner.

12. The antenna apparatus according to any preceding claim,
wherein on the conductive pattern and the core material, an opening is disposed on a region with low current distribution on the front surface of the conductive pattern, and/or
wherein the conductive pattern of the front surface is formed in an interdigital structure.

13. The antenna apparatus according to any preceding claim, further comprising:
an exterior configured to cover an entity including the conductive pattern formed on the front and back surfaces of the core material.

14. An electronic apparatus comprising:
the antenna apparatus according to any preceding claim; and
an IC (Integrated Circuit) coupled to a feeding point of the antenna apparatus.

15. The electronic apparatus according to claim 14,
wherein the electronic equipment is an RFID tag.
